# EUROPEAN PATENT SPECIFICATION

(11) **EP 3 351 346 B1**
(45) Date of publication and mention of the grant of the patent: **26.10.2022**
(21) Application number: 18151592.5
(22) Date of filing: 15.01.2018
(51) Int. Cl.: B25B 5/04, B25B 5/12, B25B 5/16, B25B 5/06, B25B 5/14

(54) **FIXING DEVICE**
FIXIERVORRICHTUNG
DISPOSITIF DE FIXATION

(30) Priority: 13.01.2017 CN 201710025048
(43) Date of publication of application: 25.07.2018
(73) Proprietor: Tyco Electronics (Shanghai) Co., Ltd., Shanghai (CN); Measurement Specialties (Chengdu) Ltd, 610213 Chendu Sichuan (CN); TE Connectivity Corporation, Berwyn, PA 19312 (US)
(72) Inventor: DENG, Yingcong, Shanghai, Shanghai (CN); GONG, Lan, Shanghai, Shanghai (CN); YING, Qian, Shanghai, Shanghai (CN); ZHANG, Dandan, Shanghai, Shanghai (CN); HU, Lvhai, Shanghai, Shanghai (CN); LIU, Yun, Shanghai, Shanghai (CN); YAN, Yong, Shanghai, Shanghai (CN); LU, Roberto Francisco - Yi, Shanghai, Shanghai (CN); ZENG, Qinglong, Shanghai, Shanghai (CN)
(74) Representative: Grünecker Patent- und Rechtsanwälte PartG mbB

(56) References cited:
- EP-A1- 0 875 964
- WO-A1-2009/015428
- DE-A1- 10 324 578
- DE-U1-202015 004 532
- US-A- 4 108 589

## Description

### Field of the Invention

Embodiments of the disclosure relate to a fixing device, and in particularly to a fixing device adapted to fix a needle-shaped element.

### Description of the Related Art

In the field of electronics manufacturing technique, a needle-shaped element is often required to be precisely positioned and fixed. For example, in a process of welding a conductive terminal to a pad on a circuit board, it is often necessary to use an elongated welding wire, for example, a lead wire, which is very elongated like a needle-shaped element. In order to ensure welding precision, the welding wire is required to be precisely positioned and fixed at a predetermined position.

Currently, in the prior art, there is no such fixing device adapted to precisely position and fix the needle-shaped member. Therefore, in the prior art, the needle-shaped element is usually manually positioned and fixed, which undoubtedly reduces the welding precision, thereby reducing the quality of a welded product.

EP 0 875 964 A1 discloses the features of the preamble of claim 1 and shows a cable hold device capable of securely preventing damage and/or deformation of cables and an apparatus for introducing cables into or through a part such as a grommet or connector. The cable hold device comprises a top portion and a base portion which are connected with each other via a hinge and define a space for accommodating at least one cable. The movement of the at least one cable in the space is restricted while the top portion and the base portion are closed with respect to one another.

DE 20 2015 004532 U1 shows a clamp for rods. The clamp features rotatable clamping plates with V-shaped grooves, which are opened towards one another, for clamping the rod.

### SUMMARY OF THE INVENTION

Embodiments of the disclosure have been made to overcome or alleviate at least one aspect of the above mentioned disadvantages.

At least one embodiment of the disclosure provides a fixing device adapted to precisely position and reliably fix the needle-shaped element.

According to one aspect of the disclosure, there is provided a fixing device adapted to fix at least one needle-shaped element, comprising: a fixing base formed with at least one positioning groove at a front end thereof; and a fixing mechanism formed with at least one pressing protrusion at a front end thereof. The needle-shaped element is adapted to be positioned in the positioning groove, and the pressing protrusion is adapted to press and hold the needle-shaped element in the positioning groove.

According to another aspect of the disclosure, the fixing mechanism comprises a first link and a second link. The first link is pivotally connected with a front end of the second link at a rear end of the first link. The first link has a connection portion pivotally connected to the fixed base between a front end and the rear end thereof, and the second link is pivotally slidably connected to the fixed base at a rear end thereof. The pressing protrusion is formed on a bottom surface of the front end of the first link.

According to another exemplary embodiment of the disclosure, the fixing base is formed with a receiving groove into which the fixing mechanism is adapted to be received.

According to further another exemplary embodiment of the disclosure, the connection portion between the front and rear ends of the first link is pivotally connected with a first pivot shaft pivotally connected to side walls of the receiving groove of the fixed base at both ends thereof.

According to yet another exemplary embodiment of the disclosure, the receiving groove of the fixing base is formed with a sliding slot in the side walls thereof. The second link is pivotally connected with a second pivot shaft, having two ends slidably received in the sliding slot of the fixed base, at the rear end of the second link.

According to still another exemplary embodiment of the disclosure, the rear end of the first link is pivotally connected with the front end of the second link by a third pivot shaft.

According to further another exemplary embodiment of the disclosure, the fixing base is further formed with a spring receiving chamber, in which a lower end of a reset spring is disposed, in a bottom of the receiving groove, the rest spring having an upper end pushed against on a lower surface of a portion between the front and rear ends of the second link.

According to yet another exemplary embodiment of the disclosure, the second link is formed with a pressing head adapted to press the second link downwardly on a top surface thereof, the pressing head being located between the front and rear ends of the second link.

According to still another exemplary embodiment of the disclosure, the second link is constructed to drive the first link to be rotated about the first pivot shaft to an open state when a downward pressing force is exerted on the pressing head. When the first link is in the open state, the pressing protrusion on the front end of the first link is separated from the positioning groove in the fixing base to allow the needle-shaped element to be arranged in or released from the positioning groove.

According to yet another exemplary embodiment of the disclosure, when the downward pressing force is exerted on the pressing head, the front end of the second link is moved downwardly and the rear end thereof is rotated about the second pivot shaft and slides along the sliding slot. When the downward pressing force is exerted on the pressing head, the rear end of the first link is rotated about the first pivot shaft downwardly and the front end thereof is rotated about the first pivot shaft upwardly so that the first link is rotatable to the opened state.

According to still another exemplary embodiment of the disclosure, when the downward pressing force exerted on the pressing head is released, the second link is urged by the reset spring upwardly to drive the first link to be rotated about the first pivot shaft into a closed state. When the first link is in the closed state, the pressing protrusion at the front end of the first link is pressed against the positioning groove of the fixing base to press and hold the needle-shaped element in the positioning groove.

According to further another exemplary embodiment of the disclosure, when the downward pressing force exerted to the pressing head is released, the front end of the second link is moved upwardly and the rear end thereof is rotated about the second pivot shaft and slides along the sliding slot. When the downward pressing force exerted on the pressing head is released, the rear end of the first link is rotated about the first pivot shaft upwardly and the front end thereof is rotated about the first pivot shaft downwardly, so that the first link is rotatable to the closed state.

According to yet another exemplary embodiment of the disclosure, the fixing base is further formed with a positioning boss protruding forwardly on the front end thereof, in which the positioning groove is formed.

According to still another exemplary embodiment of the disclosure, the fixing base is formed with a plurality of positioning grooves arranged in a row to simultaneously position a plurality of needle-shaped elements. The first link is formed with a plurality of pressing protrusions arranged in a row to simultaneously press the plurality of needle-shaped elements in place.

According to further another exemplary embodiment of the disclosure, the positioning groove is V-shaped or semicircular, and the pressing protrusion is sized to be matched with the shape of the positioning groove.

According to yet another exemplary embodiment of the disclosure, the needle-shaped element is a welding wire.

In the above-described various embodiments of the disclosure, the needle-shaped element is accurately positioned in the positioning groove of the fixed base and reliably pressed and held by the pressing protrusion in the positioning groove, thereby improving positioning accuracy and reliability of the needle-shaped element.

Other objects and advantages of the disclosure will become apparent from the following description of the disclosure when taken in conjunction with the accompanying drawings, and may give a comprehensive understanding of the disclosure.

### BRIEF DESCRIPTION OF THE DRAWINGS

The above and other features of the disclosure will become more apparent by describing in detail exemplary embodiments thereof with reference to the accompanying drawings, in which:
Fig.1 shows a schematic perspective view of a fixing device with a first link being in an open state, according to an exemplary embodiment of the disclosure;
Fig.2 shows a schematic perspective view of the fixing device with the first link being in a closed state, according to an exemplary embodiment of the disclosure;
Fig.3 shows a longitudinal cross-section view of the fixing device with the first link being in the open state, according to an exemplary embodiment of the disclosure; and
Fig.4 shows a longitudinal cross-section view of the fixing device with the first link being in the closed state according to an exemplary embodiment of the disclosure.

### DETAILED DESCRIPTION OF PREFERRED EMBODIMENTS OF THE INVENTION

The technical solution of the disclosure will be described hereinafter in further detail with reference to the following embodiments, taken in conjunction with the accompanying drawings. In the specification, the same or similar reference numerals indicate the same or similar parts. The description of the embodiments of the disclosure hereinafter with reference to the accompanying drawings is intended to explain the general inventive concept of the disclosure and should not be construed as a limitation on the disclosure.

In addition, in the following detailed description, for the sake of explanation, numerous specific details are set forth in order to provide a thorough understanding of the disclosed embodiments. It will be apparent, however, that one or more embodiments may also be practiced without these specific details. In other instances, well-known structures and devices are illustrated schematically in order to simplify the drawing.

According to a general technical concept of the disclosure, there is provided a fixing device adapted to fix at least one needle-shaped element, comprising: a fixing base formed with at least one positioning groove at a front end thereof, the needle-shaped element being adapted to be positioned in the positioning groove; and a fixing mechanism formed with at least one pressing protrusion at a front end thereof, the pressing protrusion being adapted to press and hold the needle-shaped element in the positioning groove.

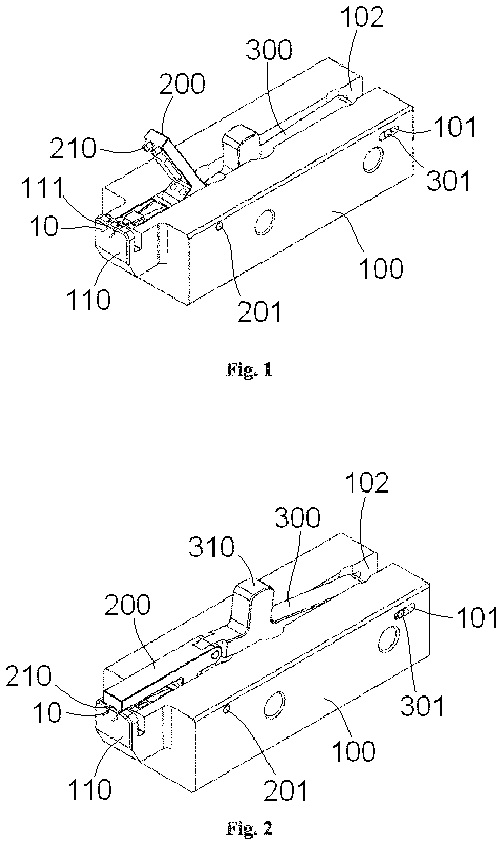

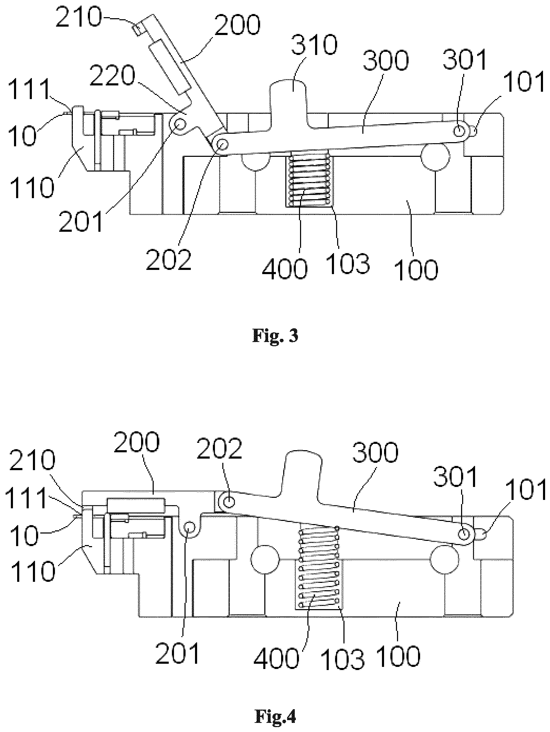

Fig.1 shows a schematic perspective view of a fixing device with a first link 200 being in an open state, according to an exemplary embodiment of the disclosure, and Fig.3 shows a longitudinal cross-section view of the fixing device with the first link 200 being in an open state, according to an exemplary embodiment of the disclosure.

As shown in FIGs.1 and 3, in the illustrated embodiment, the fixing device is adapted to precisely position and reliably fix the needle-shaped element 10.

As shown in FIGS.1 and 3, in the illustrated embodiment, the fixing device mainly comprises a fixing base 100 formed with at least one positioning groove 111 at a front end thereof and a fixing mechanism 200, 300 formed with at least one pressing protrusions 210 at a front end thereof. The needle-shaped element 10 is adapted to be positioned in the positioning groove 111, and the pressing protrusion 210 is adapted to press and hold the needle-shaped element 10 in the positioning groove 111. In this way, it is possible to precisely position and reliably fix the needle-shaped element 10 in the positioning groove 111.

Fig.2 shows a schematic perspective view of the fixing device with the first link 200 being in a closed state, according to an exemplary embodiment of the disclosure, and Fig.4 shows a longitudinal cross-section view of the fixing device with the first link 200 being in the closed state, according to an exemplary embodiment of the disclosure.

As shown in Figs.1 to 4, in an exemplary embodiment of the disclosure, the fixing mechanism 200, 300 mainly comprises: a first link 200 pivotally connected with a front end of the second link 300 at a rear end of the first link, and provided with a connection portion 220 pivotally connected to the fixed base 100 between a front end and the rear end thereof; and a second link 300 pivotally slidably connected to the fixed base 100 at a rear end thereof. The pressing protrusion 210 is formed on a bottom surface of the front end of the first link 200.

As shown in Figs. 1 to 4, in the illustrated embodiment, the fixing base 100 is formed with a receiving groove 102 into which the fixing mechanism 200, 300 is adapted to be received.

As shown in Figs.1 to 4, in the illustrated embodiment, the connection portion 220 between the front and rear ends of the first link 200 is pivotally connected with a first pivot shaft 201 pivotally connected to side walls of the receiving groove 102 of the fixed base 100 at both ends thereof.

As shown in Fig.1 to 4, in the illustrated embodiment, the receiving groove 102 of the fixing base 100 is formed with a sliding slot 101 extending in a front-rear direction in the side walls of the fixing base. The second link 300 is pivotally connected with a second pivot shaft 301, having two ends slidably received in the sliding slot 101 of the fixed base 100 at the rear end of the second link 300.

As shown in Figs.1 to 4, in the illustrated embodiment, the rear end of the first link 200 is pivotally connected with the front end of the second link 300 by a third pivot shaft 202.

As shown in Figs.1 to 4, in the illustrated embodiment, the fixing base 100 is further formed with a spring receiving chamber 103, in which a lower end of a reset spring 400 is disposed, in a bottom of the receiving groove 102. The rest spring 400 has an upper end pushed against on a lower surface of a portion between the front and rear ends of the second link 300.

As shown in Figs.1 to 4, in the illustrated embodiment, the second link 300 is formed with a pressing head 310 adapted to press the second link 300 downwardly on a top surface thereof. The pressing head 310 is located between the front and rear ends of the second link 300.

As shown in Figs.1 and 3, in the illustrated embodiment, the second link 300 may be constructed to drive the first link 200 to be rotated about the first pivot shaft 201 to an open state when a downward pressing force is exerted on the pressing head 310.

As shown in Figs.1 and 3, in the illustrated embodiment, when the first link 200 is in the open state, the pressing protrusion 210 on the front end of the first link 200 is separated from the positioning groove 111 in the fixing base 100 to allow the needle-shaped element 10 to be arranged in or released from the positioning groove 111.

As shown in Figs.1 and 3, in the illustrated embodiment, when the downward pressing force is exerted on the pressing head 310, the front end of the second link 300 is moved downwardly and the rear end thereof is rotated about the second pivot shaft 301 and slides forwardly along the sliding slot 101.

As shown in Figs.1 and 3, in the illustrated embodiment, when the downward pressing force is exerted on the pressing head 310, the rear end of the first link 200 is rotated about the first pivot shaft 201 downwardly and the front end thereof is rotated about the first pivot shaft 201 upwardly so that the first link 200 is rotatable to the opened state.

As shown in Fig. 2 and 4, in the illustrated embodiment, when the downward pressing force exerted on the pressing head 310 is released, the second link 300 is urged by the reset spring 400 upwardly to drive the first link 200 to be rotated about the first pivot shaft 201 into a closed state.

As shown in Figs. 2 and 4, in the illustrated embodiment, when the first link 200 is in the closed state, the pressing protrusion 210 at the front end of the first link 200 is pressed against the positioning groove 111 of the fixing base 100 to press and held the needle-shaped element 10 in the positioning groove 111.

As shown in Figs. 2 and 4, in the illustrated embodiment, when the downward pressing force exerted to the pressing head 310 is released, the front end of the second link 300 is moved upwardly and the rear end thereof is rotated about the second pivot shaft 301 and slides backwardly along the sliding slot 101.

As shown in Fig.2 and 4, in the illustrated embodiment, when the downward pressing force exerted on the pressing head 310 is released, the rear end of the first link 200 is rotated about the first pivot shaft 201 upwardly and the front end thereof is rotated about the first pivot shaft 201 downwardly, so that the first link 200 is rotatable to the closed state.

As shown in Figs.1 to 4, in the illustrated embodiment, the fixing base 100 is further formed with a positioning boss 110 protruding forwardly on the front end thereof, in which the positioning groove 111 is formed.

As shown in Figs.1 and 2, in the illustrated embodiment, the fixing base 100 may be formed with a plurality of positioning grooves 111 arranged in a row so as to simultaneously position a plurality of needle-shaped elements 10. Further, the first link 200 may be formed with a plurality of pressing protrusions 210 arranged in a row to simultaneously press the plurality of needle-shaped elements 10 in place.

Although not shown, in an exemplary embodiment of the disclosure, the positioning groove(s) 111 may be V-shaped or semicircular, and the pressing protrusion 210 is sized to be matched with the shape of the positioning groove 111.

In an exemplary embodiment of the disclosure, the needle-shaped element 10 as described above may be a welding wire such as a lead wire. However, the needle-shaped element 10 of the disclosure is not limited thereto, and may be other needle-shaped elements such as a needle-shaped pin of a chip.

It should be appreciated by those skilled in this art that the above embodiments are intended to be illustrative, and many modifications may be made to the above embodiments by those skilled in this art, and various structures described in various embodiments may be freely combined with each other without conflicting in configuration or principle.

Although the disclosure have been described hereinbefore in detail with reference to the attached drawings, it should be appreciated that the disclosed embodiments in the
attached drawings are intended to illustrate the preferred embodiments of the disclosure by way of example, and should not be construed as limitation to the disclosure.

Although several exemplary embodiments have been shown and described, it would be appreciated by those skilled in the art that various changes or modifications may be made to these embodiments without departing from the principles of the disclosure, the scope of which is defined by the claims.

It should be noted that, the word "comprise" doesn't exclude other elements or steps, and the word "a" or "an" doesn't exclude more than one. In addition, any reference numerals in the claims should not be interpreted as the limitation to the scope of the disclosure.

## Claims

1. A fixing device adapted to fix at least one needle-shaped element (10), comprising:
a fixing base (100) formed with at least one positioning groove (111) at a front end thereof; and
a fixing mechanism (200, 300) formed with at least one pressing protrusion (210) at a front end thereof,
wherein the needle-shaped element (10) is adapted to be positioned in the positioning groove (111), and the pressing protrusion (210) is adapted to press and hold the needle-shaped element (10) in the positioning groove (111),
**characterized in that**
the fixing mechanism (200, 300) comprises a first link (200) and a second link (300), the first link (200) being pivotally connected with a front end of the second link (300) at a rear end of the first link;
the first link (200) has a connection portion (220) pivotally connected to the fixed base (100) between a front end and the rear end thereof, and the second link (300) is pivotally slidably connected to the fixed base (100) at a rear end thereof; and
the pressing protrusion (210) is formed on a bottom surface of the front end of the first link (200).

2. The fixing device according to claim 1, **characterized in that** the fixing base (100) is formed with a receiving groove (102) into which the fixing mechanism (200, 300) is adapted to be received.

3. The fixing device according to claim 2, **characterized in that** the connection portion (220) between the front and rear ends of the first link (200) is pivotally connected with a first pivot shaft (201) pivotally connected to side walls of the receiving groove (102) of the fixed base (100) at both ends thereof.

4. The fixing device according to claim 2 or 3, **characterized in that**
the receiving groove (102) of the fixing base (100) is formed with a sliding slot (101) in the side walls thereof; and
the second link (300) is pivotally connected with a second pivot shaft (301), having two ends slidably received in the sliding slot (101) of the fixed base (100), at the rear end of the second link.

5. The fixing device according to any one of claims 1 to 4, **characterized in that** the rear end of the first link (200) is pivotally connected with the front end of the second link (300) by a third pivot shaft (202).

6. The fixing device according to any one of claims 2 to 5, **characterized in that** the fixing base (100) is further formed with a spring receiving chamber (103), in which a lower end of a reset spring (400) is disposed, in a bottom of the receiving groove (102), the rest spring (400) having an upper end pushed against on a lower surface of a portion between the front and rear ends of the second link (300).

7. The fixing device according to any one of claims 2 to 6, **characterized in that** the second link (300) is formed with a pressing head (310) adapted to press the second link (300) downwardly on a top surface thereof, the pressing head (310) being located between the front and rear ends of the second link (300).

8. The fixing device according to claim 7, **characterized in that**
the second link (300) is constructed to drive the first link (200) to be rotated about the first pivot shaft (201) to an open state when a downward pressing force is exerted on the pressing head (310); and
when the first link (200) is in the open state, the pressing protrusion (210) on the front end of the first link (200) is separated from the positioning groove (111) in the fixing base (100) to allow the needle-shaped element (10) to be arranged in or released from the positioning groove (111).

9. The fixing device according to claim 8, **characterized in that**
when the downward pressing force is exerted on the pressing head (310), the front end of the second link (300) is moved downwardly and the rear end thereof is rotated about the second pivot shaft (301) and slides along the sliding slot (101);
when the downward pressing force is exerted on the pressing head (310), the rear end of the first link (200) is rotated about the first pivot shaft (201) downwardly and the front end thereof is rotated about the first pivot shaft (201) upwardly so that the first link (200) is rotatable to the opened state.

10. The fixing device according to claim 8, **characterized in that**
when the downward pressing force exerted on the pressing head (310) is released, the second link (300) is urged by the reset spring (400) upwardly to drive the first link (200) to be rotated about the first pivot shaft (201) into a closed state; and
when the first link (200) is in the closed state, the pressing protrusion (210) at the front end of the first link (200) is pressed against the positioning groove (111) of the fixing base (100) to press and hold the needle-shaped element (10) in the positioning groove (111).

11. The fixing device according to any one of claims 7 to 10, **characterized in that**
when the downward pressing force exerted to the pressing head (310) is released, the front end of the second link (300) is moved upwardly and the rear end thereof is rotated about the second pivot shaft (301) and slides along the sliding slot (101); and
when the downward pressing force exerted on the pressing head (310) is released, the rear end of the first link (200) is rotated about the first pivot shaft (201) upwardly and the front end thereof is rotated about the first pivot shaft (201) downwardly, so that the first link (200) is rotatable to the closed state.

12. The fixing device according to any one of claims 1 to 11, **characterized in that** the fixing base (100) is further formed with a positioning boss (110) protruding forwardly on the front end thereof, in which the positioning groove (111) is formed.

13. The fixing device according to any one of claims 1 to 12, **characterized in that**
the fixing base (100) is formed with a plurality of positioning grooves (111) arranged in a row to simultaneously position a plurality of needle-shaped elements (10); and
the first link (200) is formed with a plurality of pressing protrusions (210) arranged in a row to simultaneously press the plurality of needle-shaped elements (10) in place.

14. The fixing device according to any one of claims 1 to 13, **characterized in that**
the positioning groove (111) is V-shaped or semicircular, and the pressing protrusion (210) is sized to be matched with the shape of the positioning groove (111); and
the needle-shaped element (10) is a welding wire.

## Patentansprüche

1. Fixiervorrichtung, die zum Fixieren wenigstens eines nadelförmigen Elementes (10) eingerichtet ist, wobei sie umfasst:
einen Fixiersockel (100), der mit wenigstens einer Positionier-Nut (111) an seinem vorderen Ende versehen ist; und
einen Fixiermechanismus (300), der mit wenigstens einem Pressvorsprung (210) an seinem vorderen Ende versehen ist,
wobei das nadelförmige Element (10) zum Positionieren in der Positionier-Nut (111) eingerichtet ist und der Pressvorsprung (210) so eingerichtet ist, dass er das nadelförmige Element (10) in die Positionier-Nut (111) presst und darin hält,
**dadurch gekennzeichnet, dass**
der Fixiermechanismus (200, 300) ein erstes Glied (200) und ein zweites Glied (300) umfasst, wobei das erste Glied (200) an einem hinteren Ende des ersten Gliedes schwenkbar mit einem vorderen Ende des zweiten Gliedes (300) verbunden ist;
das erste Glied (200) einen Verbindungsabschnitt (220) aufweist, der schwenkbar mit dem Fixiersockel (100) zwischen einem vorderen Ende und dem hinteren Ende desselben verbunden ist, und das zweite Glied (300) schwenkbar verschiebbar mit dem Fixiersockel (100) an einem hinteren Ende desselben verbunden ist; und
der Pressvorsprung (210) an einer unteren Fläche des vorderen Endes des ersten Gliedes (200) ausgebildet ist.

2. Fixiervorrichtung nach Anspruch 1, **dadurch gekennzeichnet, dass** der Fixiersockel (100) mit einer Aufnahmenut (102) versehen ist, und der Fixiermechanismus (200, 300) zum Aufnehmen darin eingerichtet ist.

3. Fixiervorrichtung nach Anspruch 2, **dadurch gekennzeichnet, dass** der Verbindungsabschnitt (220) zwischen dem vorderen und dem hinteren Ende des ersten Gliedes (200) schwenkbar mit einer ersten Schwenkwelle (201) verbunden ist, die schwenkbar mit Seitenwänden der Aufnahmenut (102) des Fixiersockels (100) an beiden Enden desselben verbunden ist.

4. Fixiervorrichtung nach Anspruch 2 oder 3, **dadurch gekennzeichnet, dass**
die Aufnahmenut (102) des Fixiersockels (100) mit einem Gleitschlitz (101) in ihren Seitenwänden versehen ist; und
das zweite Glied (300) schwenkbar mit einer zweiten Schwenkwelle (301) verbunden ist, deren zwei Enden verschiebbar in dem Gleitschlitz (101) des Fixiersockels (100) an dem hinteren Ende des zweiten Gliedes aufgenommen sind.

5. Fixiervorrichtung nach einem der Ansprüche 1 bis 4, **dadurch gekennzeichnet, dass** das hintere Ende des ersten Gliedes (200) über eine dritte Schwenkwelle (202) schwenkbar mit dem vorderen Ende des zweiten Gliedes (300) verbunden ist.

6. Fixiervorrichtung nach einem der Ansprüche 2 bis 5, **dadurch gekennzeichnet, dass** der Fixiersockel (100) des Weiteren mit einer Feder-Aufnahmekammer (103), in der ein unteres Ende einer Rückstellfeder (400) angeordnet ist, in einem Boden der Aufnahmenut (102) versehen ist, wobei die Rückstellfeder (400) ein oberes Ende aufweist, das an eine untere Fläche eines Abschnitts zwischen dem vorderen und dem hinteren Ende des zweiten Gliedes (300) gedrückt wird.

7. Fixiervorrichtung nach einem der Ansprüche 2 bis 6, **dadurch gekennzeichnet, dass** das zweite Glied (300) mit einem Presskopf (310) versehen ist, der so eingerichtet ist, dass er das zweite Glied (300) an einer oberen Fläche desselben nach unten drückt, wobei sich der Presskopf (310) zwischen dem vorderen und dem hinteren Ende des zweiten Gliedes (300) befindet.

8. Fixiervorrichtung nach Anspruch 7, **dadurch gekennzeichnet, dass**
das zweite Glied (300) so aufgebaut ist, dass es das erste Glied (200) so antreibt, dass es um die erste Schwenkwelle (201) herum in einen offenen Zustand gedreht wird, wenn eine nach unten gerichtete Presskraft auf den Presskopf (310) ausgeübt wird; und
wenn sich das erste Glied (200) in dem offenen Zustand befindet, der Pressvorsprung (210) an dem vorderen Ende des ersten Gliedes (200) von der Positionier-Nut (111) in dem Fixiersockel (100) getrennt wird, um zuzulassen, dass das nadelförmige Element (10) in der Positionier-Nut (111) angeordnet oder aus dieser gelöst wird.

9. Fixiervorrichtung nach Anspruch 8, **dadurch gekennzeichnet, dass**
wenn die nach unten gerichtete Presskraft auf den Presskopf (310) ausgeübt wird, das vordere Ende des zweiten Gliedes (300) nach unten bewegt wird und sein hinteres Ende um die zweite Schwenkwelle (301) herum gedreht wird und entlang des Gleitschlitzes (101) gleitet;
wenn die nach unten gerichtete Presskraft auf den Presskopf (310) ausgeübt wird, das hintere Ende des ersten Gliedes (200) um die erste Schwenkwelle (201) herum nach unten gedreht wird und das vordere Ende desselben um die erste Schwenkwelle (201) herum nach oben gedreht wird, so dass das erste Glied (200) in den geöffneten Zustand gedreht werden kann.

10. Fixiervorrichtung nach Anspruch 8, **dadurch gekennzeichnet, dass**
wenn die nach unten gerichtete Presskraft, die auf den Presskopf (310) ausgeübt wird, aufgehoben wird, das zweite Glied (300) durch die Rückstellfeder (400) nach oben gedrückt wird und das erste Glied (200) so antreibt, dass es um die erste Schwenkwelle (201) herum in einen geschlossenen Zustand gedreht wird; und
wenn sich das erste Glied (200) in dem geschlossenen Zustand befindet, der Pressvorsprung (210) an dem vorderen Ende des ersten Gliedes (200) an die Positionier-Nut (111) des Fixiersockels (100) gedrückt wird, um das nadelförmige Element (10) in die Positionier-Nut (111) zu drücken und darin zu halten.

11. Fixiervorrichtung nach einem der Ansprüche 7 bis 10, **dadurch gekennzeichnet, dass**
wenn die auf den Presskopf (310) ausgeübte nach unten gerichtete Presskraft aufgehoben wird, das vordere Ende des zweiten Gliedes (300) nach oben bewegt wird und sein hinteres Ende um die zweite Schwenkwelle (301) herum gedreht wird und entlang des Gleitschlitzes (101) gleitet; und
wenn die auf den Presskopf (310) ausgeübte nach unten gerichtete Presskraft aufgehoben wird, das hintere Ende des ersten Gliedes (200) um die erste Schwenkwelle (201) herum nach oben gedreht wird und das vordere Ende desselben um die erste Schwenkwelle (201) herum nach unten gedreht wird, so dass das erste Glied (200) in den geschlossenen Zustand gedreht werden kann.

12. Fixiervorrichtung nach einem der Ansprüche 1 bis 11, **dadurch gekennzeichnet, dass** der Fixiersockel (100) des Weiteren mit einem an seinem vorderen Ende nach vorn vorstehenden Positionier-Vorsprung (110) versehen ist, in dem die Positionier-Nut (111) ausgebildet ist.

13. Fixiervorrichtung nach einem der Ansprüche 1 bis 12, **dadurch gekennzeichnet, dass**
der Fixiersockel (100) mit einer Vielzahl von Positionier-Nuten (111) versehen ist, die in einer Reihe angeordnet sind, um gleichzeitig eine Vielzahl nadelförmiger Elemente (10) zu positionieren; und
das erste Glied (200) mit einer Vielzahl von Pressvorsprüngen (210) versehen ist, die in einer Reihe angeordnet sind, um gleichzeitig die Vielzahl nadelförmiger Elemente (10) unter Druck zu fixieren.

14. Fixiervorrichtung nach einem der Ansprüche 1 bis 13, **dadurch gekennzeichnet, dass**
die Positionier-Nut (111) V-förmig oder halbkreisförmig ist und der Pressvorsprung (210) so bemessen ist, dass er an die Form der Positionier-Nut (111) angepasst ist; und
das nadelförmige Element (10) ein Schweißdraht ist.

## Revendications

1. Dispositif de fixation adapté pour fixer au moins un élément en forme d'aiguille (10), comprenant :
une base de fixation (100) constituée avec au moins une gorge de positionnement (111) à une extrémité avant de celle-ci ; et
un mécanisme de fixation (200, 300) constitué avec au moins un débordement de pression (210) à une extrémité avant de celui-ci,
dans lequel l'élément en forme d'aiguille (10) est adapté pour être positionné dans la gorge de positionnement (111), et le débordement de pression (210) est adapté pour appuyer sur et maintenir l'élément de forme d'aiguille (10) dans la gorge de positionnement (111),
**caractérisé en ce que**
le mécanisme de fixation (200, 300) comprend une première liaison (200) et une deuxième liaison (300), la première liaison (200) étant connectée en pivotement à une extrémité avant de la deuxième liaison (300) à une extrémité arrière de la première liaison ;
la première liaison (200) présente une partie de connexion (220) connectée en pivotement à la base fixe (100) entre une extrémité avant et l'extrémité arrière de celle-ci, et la deuxième liaison (300) est connectée en pivotement en coulissement à la base fixe (100) à une extrémité arrière de celle-ci ; et
le débordement de pression (210) est constitué sur une surface de fond de l'extrémité avant de la première liaison (200).

2. Le dispositif de fixation selon la revendication 1, **caractérisé en ce que** la base de fixation (100) est constituée d'une gorge d'accueil (102) dans laquelle le mécanisme de fixation (200, 300) est adapté pour être accueilli.

3. Le dispositif de fixation selon la revendication 2, **caractérisé en ce que** la partie de connexion (220) entre les extrémités avant et arrière de la première liaison (200) est connectée en pivotement avec une première tige de pivot (201) connectée en pivotement à des parois latérales de la gorge d'accueil (102) de la base fixe (100) aux deux extrémité de celle-ci.

4. Le dispositif de fixation selon la revendication 2 ou 3, **caractérisé en ce que**
la gorge d'accueil (102) de la base de fixation (100) est constituée d'un logement coulissant (101) dans les parois latérales de celle-ci ; et
la deuxième liaison (300) est connectée en pivotement à une deuxième tige de pivot (301), présente deux extrémités accueillies en coulissement dans le logement coulissant (101) de la base fixe (100), à l'extrémité arrière de la deuxième liaison.

5. Le dispositif de fixation selon l'une quelconque des revendications 1 à 4, **caractérisé en ce que** l'extrémité arrière de la première liaison (200) est connectée en pivotement à l'extrémité avant de la deuxième liaison (300) par une troisième tige de pivot (202).

6. Le dispositif de fixation selon l'une quelconque des revendications 2 à 5, **caractérisé en ce que** la base de fixation (100) est constituée en outre d'une chambre d'accueil de ressort (103), dans laquelle une extrémité inférieure d'un ressort de rappel (400) est disposée, dans un fond de la gorge d'accueil (102), le ressort de rappel (400) présentant une extrémité supérieure poussée contre une surface inférieure d'une partie entre les extrémités avant et arrière de la deuxième liaison (300) .

7. Le dispositif de fixation selon l'une quelconque des revendications 2 à 6, **caractérisé en ce que** la deuxième liaison (300) est constituée d'une tête de pression (310) adaptée pour appuyer sur la deuxième liaison (300) vers le bas sur une surface supérieure de celle-ci, la tête de pression (310) étant placée entre les extrémités avant et arrière de la deuxième liaison (300).

8. Le dispositif de fixation selon la revendication 7, **caractérisé en ce que**
la deuxième liaison (300) est construite pour entraîner une rotation de la première liaison (200) autour de la première tige de pivot (201) vers un état ouvert lorsqu'une force de pression vers le bas est exercée sur la tête de pression (310) ; et
lorsque la première liaison (200) est dans l'état ouvert, le débordement de pression (210) sur l'extrémité avant de la première liaison (200) est séparé de la gorge de positionnement (111) dans la base de fixation (100) pour permettre à l'élément en forme d'aiguille (10) d'être disposé dans ou libéré de la gorge de positionnement (111).

9. Le dispositif de fixation selon la revendication 8, **caractérisé en ce que**
lorsque la force de pression vers le bas est exercée sur la tête de pression (310), l'extrémité avant de la deuxième liaison (300) est déplacée vers le bas et l'extrémité arrière de celle-ci est tournée autour de la deuxième tige de pivot (301) et coulisse le long du logement coulissant (101) ;
lorsque la force de pression vers le bas est exercée sur la tête de pression (310), l'extrémité arrière de la première liaison (200) est tournée autour de la première tige de pivot (201) vers le bas et l'extrémité avant de celle-ci est tournée autre de la première tige de pivot (201) vers le haut de sorte que la première liaison (200) soit pivotable vers l'état ouvert.

10. Le dispositif de fixation selon la revendication 8, **caractérisé en ce que**
lorsque la force de pression vers le bas exercée sur la tête de pression (310) est relâchée, la deuxième liaison (300) est mobilisée par le ressort de rappel (400) vers le haut pour entraîner une rotation de la première liaison (200) autour de la première tige de pivot (201) vers un état fermé ; et
lorsque la première liaison (200) est dans l'état fermé, le débordement de pression (210) sur l'extrémité avant de la première liaison (200) est appuyé contre la gorge de positionnement (111) de la base de fixation (100) pour appuyer sur et maintenir l'élément en forme d'aiguille (10) dans la gorge de positionnement (111).

11. Le dispositif de fixation selon l'une quelconque des revendications 7 à 10, **caractérisé en ce que**
lorsque la force de pression vers le bas exercée sur la tête de pression (310) est relâchée, l'extrémité arrière de la deuxième liaison (300) est déplacée vers le haut et l'extrémité arrière de celle-ci est tournée autour de la deuxième tige de pivot (301) et coulisse le long du logement coulissant (101) ; et
lorsque la force de pression vers le bas exercée sur la tête de pression (310) est relâchée, l'extrémité arrière de la première liaison (200) est tournée autour de la première tige de pivot (201) vers le haut et l'extrémité avant de celle-ci est tournée autour de la première tige de pivot (201) vers le bas, de sorte que la première liaison (200) soit pivotable vers l'état fermé.

12. Le dispositif de fixation selon l'une quelconque des revendications 1 à 11, **caractérisé en ce que** la base de fixation (100) est constituée en outre avec une protrusion de positionnement (110) débordant vers l'avant sur l'extrémité avant de celle-ci, dans laquelle la gorge de positionnement (111) est constituée.

13. Le dispositif de fixation selon l'une quelconque des revendications 1 à 12, **caractérisé en ce que**
la base de fixation (100) est constituée d'une pluralité de gorges de positionnement (111) disposées en rang pour positionner simultanément une pluralité d'éléments en forme d'aiguille (10) ; et
la première liaison (200) est constituée d'une pluralité de débordements de pression (210) disposés en rang pour appuyer simultanément sur la pluralité d'éléments en forme d'aiguille (10) et la maintenir en place.

14. Le dispositif de fixation selon l'une quelconque des revendications 1 à 13, **caractérisé en ce que**
la gorge de positionnement (111) est en forme de V ou semi-circulaire, et le débordement de pression (210) est dimensionné pour correspondre à la forme de la gorge de positionnement (111) ; et
l'élément en forme d'aiguille (10) est un fil de soudage.
